# EUROPÄISCHE PATENTSCHRIFT

(11) **EP 0 355 799 B1**
(45) Veröffentlichungstag und Bekanntmachung des Hinweises auf die Patenterteilung: **05.04.1995**
(21) Anmeldenummer: 89115504.6
(22) Anmeldetag: 23.08.1989
(51) Int. Cl.: H01L 21/331, H01L 21/20, H01L 21/285

(54) **Verfahren zur Herstellung eines Bipolartransistors**
Method of producing a bipolar transistor
Procédé pour fabriquer d'un transistor bipolaire

(30) Priorität: 25.08.1988 DE 3828809
(43) Veröffentlichungstag der Anmeldung: 28.02.1990
(73) Patentinhaber: Licentia Patent-Verwaltungs-GmbH, 60596 Frankfurt (DE); TEMIC TELEFUNKEN microelectronic GmbH, 74072 Heilbronn (DE)
(72) Erfinder: Kasper, Erich, Dr. rer. nat., D-7914 Pfaffenhofen (DE); König, Ulf, Dr. Ing., D-7900 Ulm (DE); Wörner, Klaus, Dipl.-Ing., D-7105 Leingarten (DE)

(56) Entgegenhaltungen:
- EP-A- 0 125 943
- EP-A- 0 189 136
- DE-A- 3 545 238
- US-A- 4 507 853
- US-A- 4 663 831
- IBM TECHNICAL DISCLOSURE BULLETIN. vol. 26, no. 6, November 1983, NEW YORK USSeiten 3022 - 3024; F.S.J.LAI: "Dielectrically isolated CMOS structurefabricated by reverse trench process"

## Beschreibung

Die Erfindung betrifft ein Verfahren zur Herstellung von Halbleiterbauelementen nach dem Oberbegriff des Patentanspruchs 1.

Das Verfahren wird insbesondere zur Herstellung von Bipolartransistoren aus Si oder III/V-Halbleiterverbindungen verwendet. Derartige Bipolartransistoren werden u.a. in Si-VLSI (very large scale integration) oder in multifunktionale Schaltungen, z.B. optoelektronische Schaltkreise integriert.

Bei herkömmlichen Herstellungsverfahren von Bipolartransistoren erfolgt die Bauelementstrukturierung, d. h. die Herstellung und/oder Kontaktierung der aktiven Bauelementschichten durch Implantations- und/oder Diffusionsprozesse, die meist bei hohen Temperaturen (ca. 800 - 1000°) ausgeheilt bzw. durchgeführt werden. Die lateralen Abmessungen der einzelnen Transistorschichten sind unterschiedlich, insbesondere ist die laterale Ausdehnung der Basisschicht häufig größer als die der Emitterschicht.

Der Erfindung liegt die Aufgabe zugrunde ein Verfahren zur Herstellung eines Bipolartransistors anzugeben, das möglichst wenige unterschiedliche Prozeßschritte erfordert und für verschiedene Halbleitermaterialien verwendbar ist.

Die erfindungsgemäßen Merkmale sind den Patentansprüchen 1 und 2 zu entnehmen. Vorteilhafte Ausgestaltungen sind den Unteransprüchen zu entnehmen.

Das erfindungsgemäße Verfahren hat den Vorteil, daß die Bauelementstrukturierung während und durch die verwendeten Epitaxieverfahren erfolgt und nicht wie bei herkömmlichen Verfahren nach dem Aufwachsen der Halbleiterschichten. Die Emitter- und Basisschicht werden in einem Epitaxieprozeß hergestellt. Vorteilhafterweise besitzen Emitter- und Basisschicht gleiche laterale Abmessungen, so daß parasitäre Widerstände vermieden werden.

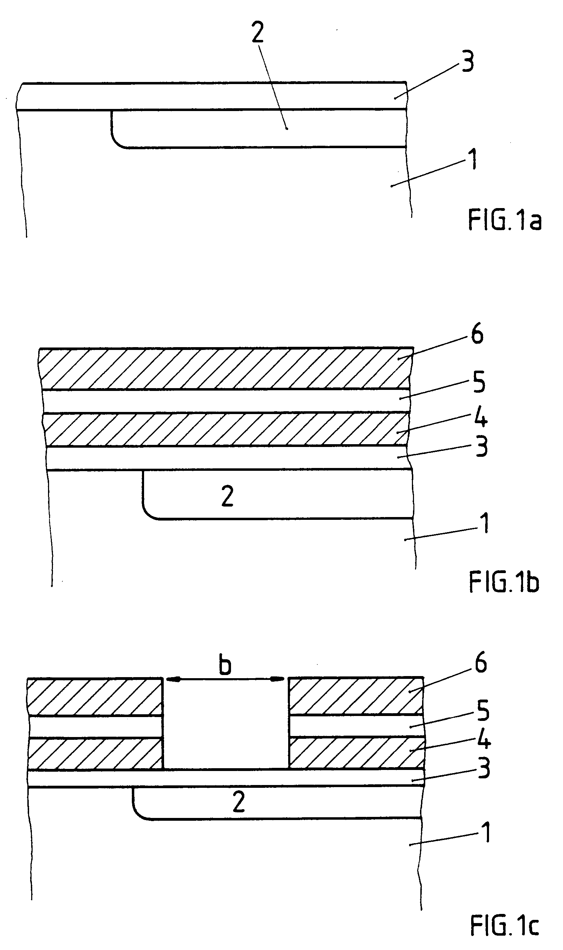

Die Erfindung wird anhand von Ausführungsbeispielen erläutert unter Bezugnahme auf schematische Zeichnungen. In den Figuren 1a-1f, 2e-2j, 3a,b sind die verschiedenen Verfahrensschritte dargestellt.

Gemäß Fig 1a wird in ein einkristallines Substrat 1 aus z.B. Si, GaAs oder InP eine hochdotierte, vergrabene Halbleiterzone 2 implantiert oder diffundiert. Als Dotiermaterial wird bespielsweise As mit einer Dotierkonzentration von 5·10¹⁸ - 5·10²⁰ Ladungsträger pro cm³ verwendet. Die Dotiertiefe beträgt etwa 1 bis 10 »m. Alternativ kann auf ein z.B. hochohmiges Substrat 1 eine hochdotierte Halbleiterschicht als Kontaktschicht und/oder Pufferschicht aufgebracht werden. Die hochdotierte Halbleiterschicht besteht z.B. aus Si, GaAs oder InP und besitzt eine As-Dotierkonzentration von 5·10¹⁸ - 5·10²⁰ cm⁻³.

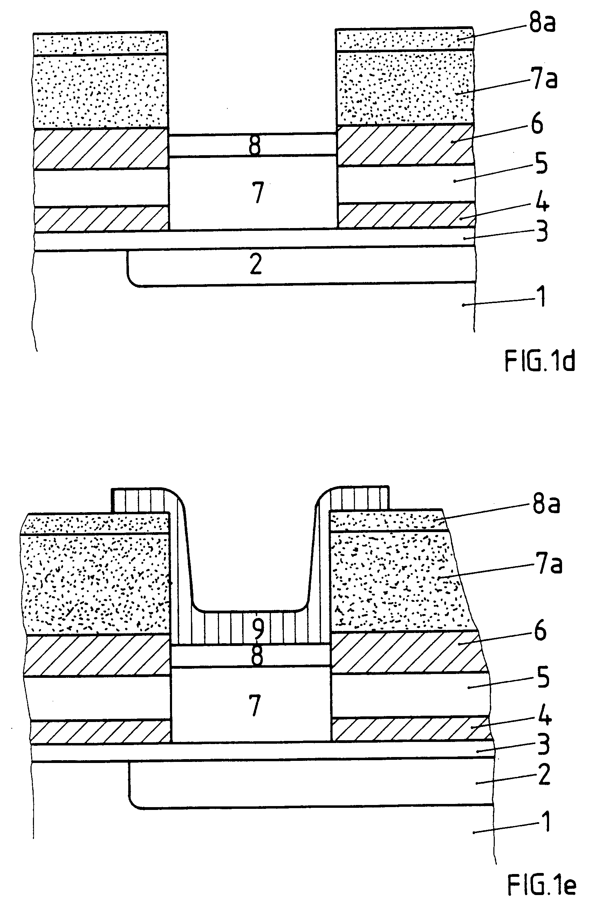

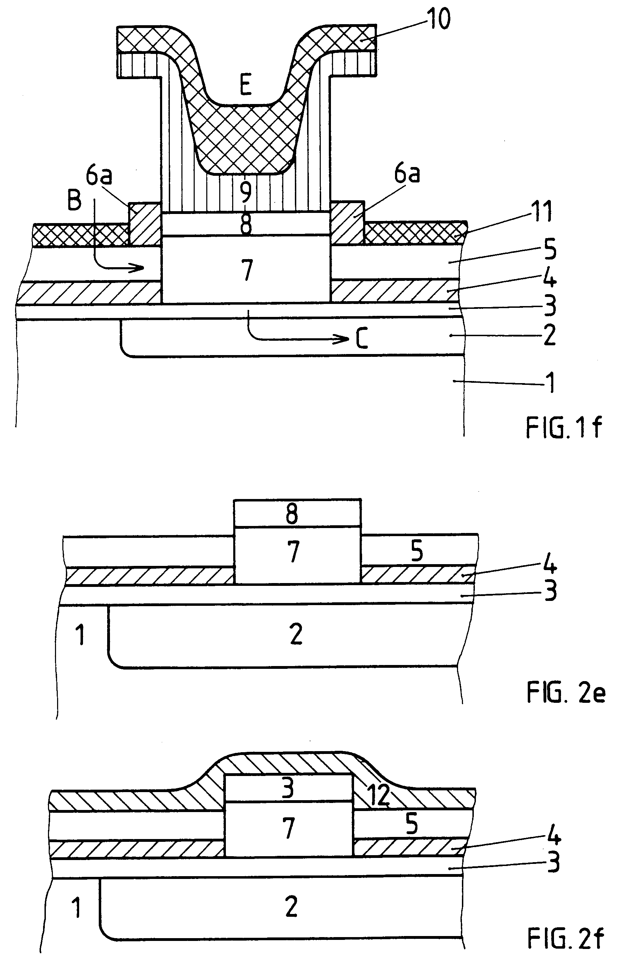

Darauf wird eine n⁻-dotierte Kollektorschicht 3 epitaktisch aufgewachsen. Je nach Wahl des Substrates 1 sind unterschiedliche gitterangepaßte oder gitterfehlangepaßte Halbleitermaterialien für die Kollektorschicht geeignet. Wird auf ein Si-Substrat oder Si-Kontaktschicht z.B. eine Si-Schicht aufgewachsen, so wird ein gitterangepaßter Kollektor mit großem Bandabstand gebildet. Wird dagegen eine SiGe-, oder GaAs- oder InGaAs-Schicht auf ein Si-Substrat oder Si-Kontaktschicht gewachsen, so entsteht ein gitterfehlangepaßter Kollektor mit geringem Bandabstand. Bei einem GaAs-Substrat oder GaAs-Kontaktschicht und einer GaAs-Kollektorschicht bzw. GaAlAs-Kollektorschicht wird ein gitterangepaßter Kollektor mit geringem Bandabstand bzw. großem Bandabstand gebildet. Verwendet man ein InP-Substrat oder InP-Kontaktschicht und eine InP- bzw. InGaAs-Kollektorschicht entsteht ein gitterangepaßter Kollektor mit großem bzw. kleinem Bandabstand.Die Kontaktierung der Kollektorschicht 3 erfolgt über die Halbleiterzone 2. Auf die Kollektorschicht 3 wird eine erste, isolierende Schicht 4 entweder thermisch oder durch CVD (chemical vapor deposition) bzw. Plasma-Deposition aufgewachsen (Fig. 1b). Die erste isolierende Schicht 4 besteht z.B. aus einem Oxid und besitzt eine Schichtdicke von ca. 0,05 »m. In einem weiteren Epitaxieschritt wird auf die erste, isolierende Schicht 4 eine p⁺⁺-dotierte, polykristalline Halbleiterschicht 5 aufgewachsen (Fig. 1b). Das Halbleitermaterial für diese Schicht 5 besteht je nach gewählter Kollektorschicht 3 aus Si, SiGe, GaAs, InGaAs mit einer Ladungsträgerkonzentration von 5·10¹⁸ - 5·10²⁰cm⁻³ und besitzt eine Schichtdicke von ca. 0,1 - 0,2 »m. Als Dotiermaterial für eine polykristalline Si-Schicht ist vorzugsweise B geeignet, für eine GaAs-Schicht z.B. Be. Die hochdotierte Halbleiterschicht 5 dient zur seitlichen Kontaktierung der Basis des herzustellenden Bipolartransistors. Auf die hochdotierte Halbleiterschicht 5 wird eine zweite, isolierende Schicht 6 mit einer analogen Zusammensetzung wie die erste isolierende Schicht 4 aufgebracht (Fig. 1b). Die Schichtdicke der zweiten, isolierenden Schicht 6 ist so zu wählen, daß die später epitaktisch zu wachsende Emitterschicht in die zweite isolierende Schicht 6 eingebettet wird. Anschließend wird durch einen Naß- oder Trockenätzprozeß ein Graben mit einer Breite b von ungefähr 0,2 bis 20»m in die Schichtenfolge geätzt (Fig. 1c). Die Kollektorschicht 3 wird teilweise freigelegt, so daß durch ein nachfolgendes selektives Epitaxieverfahren, z.B. MBE (molecular beam epitaxy) oder MOCVD (metal organic vapor deposition), die Basis- und die Emitterschicht 7,8 auf die Kollektorschicht 3 gewachsen werden (Fig. 1d). Die Basisschicht 7 besteht je nach Aufbau der Kollektorschicht 3 aus Si, SiGe, GaAs, InGaAs mit einer positiven Ladungsträgerkonzentration von 10¹⁷-5·10¹⁸ cm⁻³ und besitzt eine Schichtdicke von ca. 0,2-0,5»m. Die Emitterschicht 8 besteht z.B. aus Si, GaAlAs, InP mit einer negativen Ladungsträgerkonzentration von 10¹⁸-10²⁰ cm⁻³ und besitzt eine Schichtdicke von 0,1 bis 0,4»m. Auf der zweiten, isolierenden Schicht 6 scheiden sich beim Epitaxieprozeß polykristalline Halbleiterschichten 7a, 8a mit der gleichen Zusammensetzung wie die Basis- und Emitterschicht 7, 8 ab. Die Schichtdicken der einzelnen Schichten der Bipolartransistorstruktur sind derart zu wählen, daß die polykristalline Schicht 7a durch die zweite isolierende Schicht 6 von der Emitterschicht 8 und die Emitterschicht 8 wiederum von der hochdotierten, polykristallinen Halbleiterschicht 5 elektrisch separiert sind. Die Basisschicht 7 ist dicker als die Summe der Schichtdicken der ersten, isolierenden Schicht 4 und der polykristallinen, hochdotierten Halbleiterschicht 5. Die Emitter- und Basisschicht 7, 8 sind insgesamt dünner als die Summe der Schichtdicken aus erster, isolierender Schicht 4, polykristalliner, hochdotierter Halbleiterschicht 5 und zweiter, isolierender Schicht 6 (Fig. 1d). Die Oberfläche der Bauelementstruktur wird ganzflächig metallisiert, z. B. mit Al oder Au oder AuGe oder AuSb mit einer Schichtdicke von etwa 0,05 bis 0,2 »m. Durch seitliche Strukturierung der Kontaktschicht entsteht der Emitterkontakt 9 (Fig. 1e). Die polykristallinen Halbleiterschichten 7a, 8a werden durch einen isotropen Ätzprozeß entfernt. Die Ätze stoppt an der zweiten isolierenden Schicht 6 und am Emitterkontakt 9. Durch einen anisotropen Ätzprozeß wird die zweite isolierende Schicht 6 entfernt (Fig. 1f). Der überhängende Emitterkontakt 9 bewirkt, daß ein Oxidring 6a zurückbleibt, der den Emitter/Basis-Übergang einbettet. Eine zweite ganzflächige Metallisierung der Oberfläche der Bauelementstruktur mit z.B. Al oder Au oder AuZn mit einer Schichtdicke von 0,05 bis 0,2 »m ergibt die auf der hochdotierten, polykristallinen Halbleiterschicht 5 selbstjustierend hergestellten Basiskontakte 11, die durch den Oxidring 6a von der Emitter- und Basisschicht 8,7 getrennt sind.

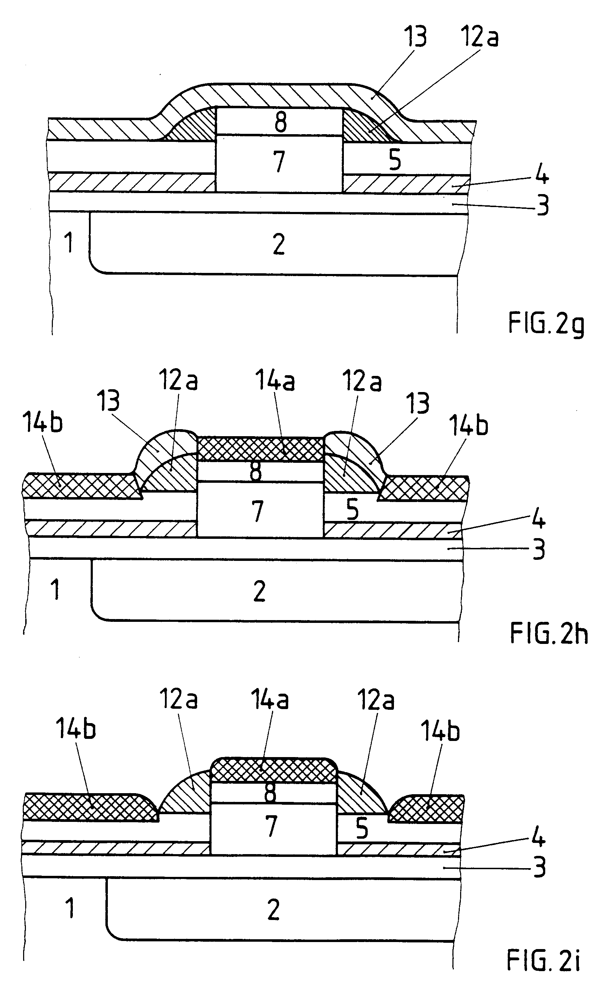

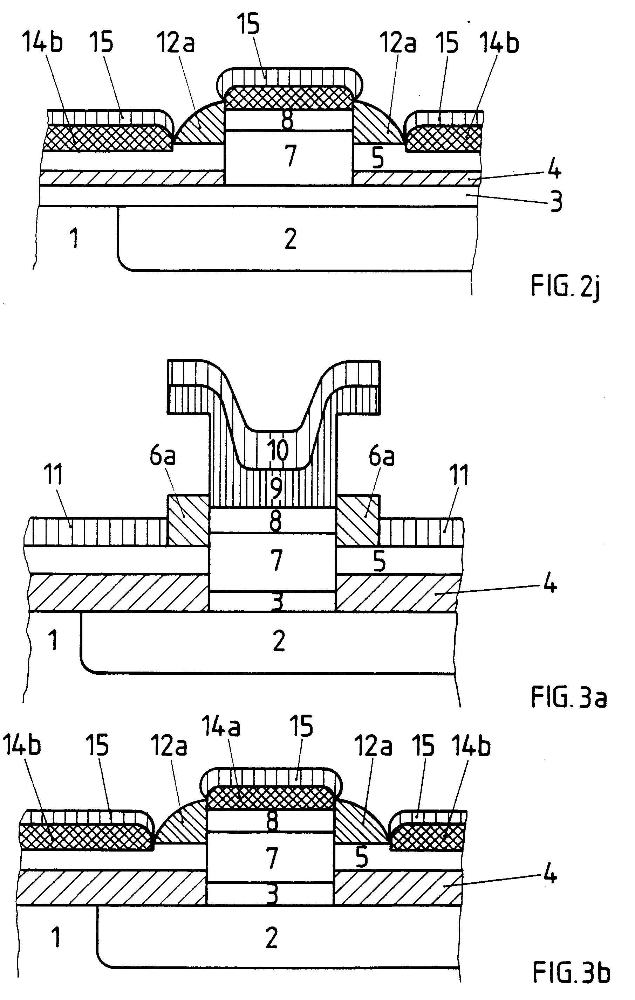

Eine weitere vorteilhafte Modifikation der Verfahrensschritte zur Herstellung von Bipolartransistoren besteht darin, daß nach dem Abscheiden der Emitter- und Basisschicht 8,7 (Fig. 1a bis 1d) die polykristallinen Halbleiterschichten 7a, 8a und die zweite isolierende Schicht 6 durch ein sog. Strippverfahren entfernt werden (Fig. 2e). Die Oberfläche der Bauelementstruktur wird ganzflächig mit Oxid, vorzugsweise Fließglas mit einer Schichtdicke von 0,1 bis 0,5 »m beschichtet (Fig. 2f). Durch reaktives Ionen-Ätzen wird die Oxidschicht 12 weggeätzt bis auf einen Oxidrand 12a. Dieser sog. "Spacer" schützt beim Bipolartransistor den Emitter/Basis-Übergang. Vorzugsweise unter Ultrahochvakuum-Bedingungen z.B. in einer MBE-Anlage wird die Oberfläche der Bauelementstruktur mit Metall bedampft (Fig. 2g). Bestehen die Halbleiterschichten 5, 8 aus Si , so werden als Bedamfungsmaterial vorzugsweise Ni oder Co und bei III/V-Halbleiterverbindungen Ge oder Zn oder Sb verwendet. Durch einen Temperprozeß bei etwa 400 bis 700 °C verbindet sich die Metallschicht 13 mit den Halbleiterschichten 5,8 und es entsteht eine eutektische Verbindung. Die Halbleiterschichten 5, 8 werden dadurch dünner und es bilden sich die Kontakte 14a, 14b (Fig. 2h). Anschließend wird mit einer metallspezifischen Ätze die auf dem Oxid verbleibende Metallschicht 13 entfernt (Fig. 2i). Die Kontakte 14a, 14b werden nochmals z.B. mit Au galvanisch verstärkt. Es entstehen die Goldschichten 15 (Fig. 2j).

Durch eine weitere Modifikation der angegebenen Herstellungsschritte sind alle Transistorschichten in einem Epitaxieprozeß herstellbar. Die erste isolierende Schicht 4 wird auf dem Substrat 1 oder der Kontaktschicht abgeschieden. Die Schichtdicke der ersten isolierenden Schicht beträgt ca. 0,2 »m. Anschließend wird ein Fenster in die isolierende Schicht 4 geätzt und die vergrabene Halbleiterzone 2 oder die Kontaktschicht teilweise freigelegt. Mit einem selektiven Epitaxieprozeß werden Kollektor-, Basis- und Emitterschicht 3,7,8 gewachsen. Die weiteren Verfahrensschritte sind wie oben beschrieben durchzuführen. Es entstehen die in den Figuren 3a, 3b dargestellten Transistorstrukturen.

Es sind beispielsweise folgende Bipolartransistoren herstellbar:
a) Emitter-, Basis- und Kollektor sind aus Si aufgebaut und bilden eine Homostruktur.
b) Basis und Kollektor sind aus SiGe oder GaAs und der Emitter aus Si oder GaAlAs aufgebaut und bilden eine Heterostruktur.
c) Kollektor und Emitter sind aus Si oder InP und die Basis aus SiGe oder InGaAs aufgebaut und bilden eine Doppelheterostruktur.

Die Bipolartransistoren sind sowohl mit einer npn-als auch pnp-Struktur herstellbar. Der Aufbau der Bipolartransistoren ist nicht auf die in den Ausführungsbeispielen angegebenen Halbleitermaterialien beschränkt.

## Patentansprüche

1. Verfahren zur Herstellung eines Bipolartransistors, bei welchem
- auf einem Halbleitersubstrat (1) eine erste isolierende Schicht (4), eine erste polykristalline Halbleiterschicht (5) und eine zweite isolierende Schicht (6) abgeschieden werden,
- durch die Schichtenfolge aus erster isolierender Schicht, erster polykristalliner Halbleiterschicht und zweiter isolierender Schicht ein Graben geätzt wird,
- mittels selektiver Epitaxie in dem Graben eine einkristalline Halbleiter-Schichtenfolge gewachsen wird, die zumindest eine Basisschicht (7) und eine Emitterschicht (8) umfaßt, wobei die Basisschicht durch die polykristalline Halbleiterschicht (7) seitlich kontaktiert wird,
dadurch gekennzeichnet, daß
- bei der selektiven Epitaxie gleichzeitig auf der zweiten isolierenden Schicht (6) weitere polykristalline Halbleiterschichten (7a,8a) aufgewachsen werden,
- ein über die einkristalline Halbleiterschichtenfolge seitlich auf den weiteren polykristallinen Halbleiterschichten (7a,8a) überhängender Emitterkontakt (9) erzeugt wird,
- die weiteren polykristallinen Schichten (7a, 8a) durch einen isotropen Ätzprozeß entfernt werden, und die zweite isolierende Schicht (6) durch einen anisotropen Ätzprozeß bis auf einen die einkristalline Schichtenfolge umgebenden Rand (6a) entfernt wird,
- auf der ersten polykristallinen Halblieterschicht (5) Basiskontakte (11) hergestellt werden.

2. Verfahren zur Herstellung eines Bipolartransistors, bei welchem
- auf einem Halbleitersubstrat (1) eine erste isolierende Schicht (4), eine erste polykristalline Halbleiterschicht (5) und eine zweite isolierende Schicht (6) abgeschieden werden,
- durch die Schichtenfolge aus erster isolierender Schicht, erster polykristalliner Halbleiterschicht und zweiter isolierender Schicht ein Graben geätzt wird,
- mittels selektiver Epitaxie in dem Graben eine einkristalline Halbleiter-Schichtenfolge gewachsen wird, die zumindest eine Basisschicht (7) und eine Emitterschicht (8) umfaßt, wobei die Basisschicht durch die polykristalline Halbleiterschicht (7) seitlich kontaktiert wird,
dadurch gekennzeichnet, daß
- nach dem Aufwachsen der einkristallinen Halbleiter-Schichtenfolge die zweite isolierende Schicht (6) sowie darauf abgeschiedene weitere polykristalline Schichten (7a,8a) entfernt werden,
- ganzflächig eine Oxidschicht (12) aufgebracht wird,
- die Oxidschicht bis auf einen die einkristalline Schichtenfolge (7,8) umgebenden Oxidrand (12a) durch reaktives Ionenätzen entfernt wird,
- ganzflächig eine Metallschicht (13) aufgebracht wird
- durch einen Temperprozeß Bereiche (14a,14b) eutektischer Verbindungen zwischen den Halbleiterschichten (5,8) und der Metallschicht erzeugt werden,
- mittels einer metallspezifischen Ätze die verbleibende Metallschicht auf dem Oxidrand entfernt wird.

3. Verfahren nach Anspruch 1 oder 2, dadurch gekennzeichnet, daß die erste isolierende Schicht (4) unmittelbar auf dem Substrat (1) oder einer Kontaktschicht abgeschieden wird, und daß bei der selektiven Epitaxie als erste Schicht der einkristallinen Schichtenfolge in dem Graben eine gering dotierte Kollektorschicht abgeschieden wird.

4. Verfahren nach Anspruch 1 oder 2, dadurch gekennzeichnet, daß vor dem Abscheiden der ersten isolierenden Schicht (4) eine gering dotierte Kollektorschicht auf dem Substrat (1) oder einer Kontaktschicht aufgewachsen wird.

5. Verfahren nach Anspruch 3, dadurch gekennzeichnet, daß die Kollektorschicht dünner gewachsen wird als die erste isolierende Schicht (4), und daß die Basisschicht (7) dicker gewachsen wird als die erste polykristalline Halbleiterschicht (5).

6. Verfahren nach Anspruch 4, dadurch gekennzeichnet, daß die Basisschicht (7) dicker gewachsen wird als die Summe der ersten isolierenden Schicht (4) und der ersten polykristallinen Halbleiterschicht (5), und daß die Basisschicht (7) und die Emitterschicht (8) insgesamt dünner gewachsen werden als die Summe der ersten isolierenden Schicht (4), der ersten polykristallinen Schicht (5) und der zweiten isolierenden Schicht (6).

## Claims

1. Method of producing a bipolar transistor, in which
- a first insulating layer (4), a first polycrystalline semiconductor layer (5) and a second insulating layer (6) are precipitated on a semiconductor substrate (1),
- a trench is etched through the layer sequence of the first insulating layer, the polycrystalline semiconductor layer and the second insulating layer and
- a monocrystalline semiconductor layer sequence, which comprises at least a base layer (7) and an emitter layer (8), is grown in the trench by means of selective epitaxy, wherein the base layer is made contact with laterally by the polycrystalline semiconductor layer (7a),
characterised thereby, that
- further polycrystalline semiconductor layers (7a, 8a) are grown on the second insulating layer (6) simultaneously with the selective epitaxy,
- an emitter contact (9) is produced, which overhangs on the further polycrystalline semiconductor layers (7a, 8a) laterally beyond the monocrystalline semiconductor layer sequence,
- the further polycrystalline semiconductor layers (7a, 8a) are removed by an isotropic etching process and the second insulating layer (6) is removed, except for a rim (6) surrounding the monocrystalline semiconductor layer sequence,
- by an anisotropic etching process and base contacts (11) are produced on the first polycrystalline semiconductor layer (5).

2. Method of producing a bipolar transistor, in which
- a first insulating layer (4), a first polycrystalline semiconductor layer (5) and a second insulating layer (6) are precipitated on a semiconductor substrate (1),
- a trench is etched through the layer sequence of the first insulating layer, the polycrystalline semiconductor layer and the second insulating layer and
- a monocrystalline semiconductor layer sequence, which comprises at least a base layer (7) and an emitter layer (8), is grown in the trench by means of selective epitaxy, wherein the base layer is made contact with laterally by the polycrystalline semiconductor layer (7a),
characterised thereby, that
- the second insulating layer (6) as well as the further polycrystalline semiconductor layers (7a, 8a) precipitated thereon are removed after the growing-on of the monocrystalline semiconductor layer sequence,
- an oxide layer (12) is applied over the entire area,
- the oxide layer, except for a rim (12a) surrounding the monocrystalline semiconductor layer sequence (7, 8) is removed by reactive ion etching,
- a metal layer (13) is applied over the entire area,
- regions (14a, 14b) of eutectic connections between the semiconductor layers (5, 8) and the metal layer are produced by a tempering process and
- the remaining metal layer on the oxide rim is removed by an etch specific for the metal.

3. Method according to claim 1 or 2, characterised thereby, that the first insulating layer (4) is precipitated directly on the substrate (1) or a contact layer and that a slightly doped collector layer is precipitated in the trench as first layer of monocrystalline semiconductor layer sequence during the selective epitaxy.

4. Method according to claim 1 or 3, characterised thereby, that a slightly doped collector layer is grown on the substrate (1) or a contact layer before the precipitation of the first insulating layer (4).

5. Method according to claim 3, characterised thereby, that the collector layer is grown to be thinner than the first insulating layer (4) and the base layer (7) is grown to be thicker than the first polycrystalline semiconductor layer (5).

6. Method according to claim 4, characterised thereby, that the base layer (7) is grown to be thicker than the sum of the first insulating layer (4) and the first polycrystalline semiconductor layer (5) and that the base layer (7) and the emitter layer (8) together are grown to be thinner than the sum of the first insulating layer (4), the first polycrystalline semiconductor layer (5) and the second insulating layer (6).

## Revendications

1. Procédé pour la réalisation d'un transistor bipolaire, dans lequel
- sur un substrat de semi-conducteur (1), une première couche (4) isolante, une première couche de semiconducteur (5) polycristalline et une deuxième couche (6) isolante sont déposées,
- à travers la suite de couches, constituée d'une première couche isolante, d'une première couche de semiconducteur polycristalline et d'une deuxième couche isolante, une tranchée est créée par attaque,
- au moyen d'épitaxie sélective, dans la tranchée, une suite de couches de semi-conducteur monocristallines est réalisée par croissance, qui comprend au moins une couche de base (7) et une couche d'émetteur (8), la couche de base étant mise en contact latéralement par la couche de semi-conducteur (7) polycristalline,
caractérisé en ce que
- lors de l'épitaxie sélective, en même temps, sur la deuxième couche (6) isolante, d'autres couches de semiconducteur (7a, 8a) polycristallines sont réalisées par croissance,
- un contact d'émetteur (9) en porte-à-faux est engendré, au-dessus de la suite de couches de semi-conducteur monocristalline, latéralement, sur les autres couches de semiconducteur (7a, 8a) polycristallines,
- les autres couches (7a, 8a) polycristallines sont enlevées par un processus d'attaque isotropique, et la deuxième couche (6) isolante est enlevée par un processus d'attaque anisotropique, jusque sur un bord (6a) entourant la suite de couches monocristallines,
- sur la première couche de semi-conducteur (5) polycristalline, des contacts de base (11) sont réalisés.

2. Procédé pour la réalisation d'un transistor bipolaire, lors duquel
- sur un substrat de semi-conducteur (1), une première couche (4) isolante, une première couche de semiconducteur (5) polycristalline et une deuxième couche (6) isolante sont déposées,
- à travers la suite de couches, constituée d'une première couche isolante, d'une première couche de semiconducteur polycristalline et d'une deuxième couche isolante, une tranchée est créée par attaque,
- au moyen d'épitaxie sélective, dans la tranchée, une suite de couches de semi-conducteur monocristallines est réalisée par croissance, qui comprend au moins une couche de base (7) et une couche d'émetteur (8), la couche de base étant mise en contact latéralement par la couche de semi-conducteur (7) polycristalline,
caractérisé en ce que
- après la formation par croissance de la suite de couches de semi-conducteur monocristallines, la deuxième couche (6) isolante ainsi que d'autres couches (7a, 8a) polycristallines déposées sur celle-ci sont enlevées,
- une couche d'oxyde (12) est déposée sur toute la surface,
- la couche d'oxyde est enlevée par une attaque ionique réactive jusque sur un bord d'oxyde (12a) entourant la suite de couches (7, 8) monocristallines,
- une couche de métal (13) est déposée sur toute la surface,
- grâce à un processus de recuit, des régions (14a, 14b) de liaisons eutectiques sont engendrées entre les couches de semi-conducteur (5, 8) et la couche de métal,
- au moyen d'une attaque spécifique pour le métal, la couche de métal restante, sur le bord d'oxyde, est enlevée.

3. Procédé selon la revendication 1 ou la revendication 2, caractérisé en ce que la première couche (4) isolante est déposée directement sur le substrat (1) ou à une couche de contact, et en ce que, lors de l'épitaxie sélective, comme première couche de la suite de couches monocristallines, dans la tranchée, une couche de collecteur faiblement dopée est déposée.

4. Procédé selon la revendication 1 ou la revendication 2, caractérisé en ce que, avant le dépôt de la première couche (4) isolante, une couche de collecteur faiblement dopée est formée par croissance sur le substrat (1) ou à une couche de contact.

5. Procédé selon la revendication 3, caractérisé en ce que la couche de collecteur est formée par croissance plus mince que la première couche (4) isolante, et en ce que la couche de base (7) est formée par croissance plus épaisse que la première couche de semi-conducteur (5) polycristalline.

6. Procédé selon la revendication 4, caractérisé en ce que la couche de base (7) est formée par croissance plus épaisse que la somme de la première couche (4) isolante et de la première couche de semi-conducteur (5) polycristalline, et que la couche de base (7) et la couche d'émetteur (8), ensemble, sont formées par croissance plus minces que la somme de la première couche (4) isolante, de la première couche (5) polycristalline et de la deuxième couche (6) isolante.
